(19) Europäisches Patentamt
European Patent Office
Office européen des brevets

(11) **EP 4 477 777 A1**

(12) **EUROPEAN PATENT APPLICATION**

(43) Date of publication:
18.12.2024 Bulletin 2024/51

(21) Application number: 23178911.6

(22) Date of filing: 13.06.2023

(51) International Patent Classification (IPC):
*C23C 16/455* (2006.01)     *C23C 16/458* (2006.01)
*C23C 16/44* (2006.01)     *C23C 16/46* (2006.01)
*G21K 7/00* (2006.01)     *G02B 3/08* (2006.01)
*G02B 5/18* (2006.01)     *G21K 1/06* (2006.01)
*C23C 16/02* (2006.01)

(52) Cooperative Patent Classification (CPC):
C23C 16/4584; C23C 16/0227; C23C 16/45519;
C23C 16/45551; C23C 16/45565; C23C 16/458;
C23C 16/46; G02B 3/08; G02B 5/1876; G21K 1/06;
G21K 7/00

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: deepXscan GmbH
01324 Dresden (DE)

(72) Inventors:
• **Zschech, Ehrenfried**
01324 Dresden (DE)
• **Richter, Matthias**
01324 Dresden (DE)
• **Feser, Michael**
01324 Dresden (DE)

(74) Representative: **Eisenführ Speiser**
**Patentanwälte Rechtsanwälte PartGmbB**
**Postfach 31 02 60**
**80102 München (DE)**

(54) **REACTOR AND METHOD FOR DEPOSITING ATOMIC LAYERS AND FOR FABRICATING FRESNEL ZONE PLATES**

(57) The present invention relates to a reactor and to a method for depositing one or more atomic layers of at least one material onto a substrate. The reactor comprises a reaction chamber accommodating a showerhead, a base stage and at least one substrate holder. The showerhead comprises at least one gas outlet that is configured for providing a gas stream of the at least material or of at least one component of the at least one material. The base stage is rotatable around a base stage rotation axis. The at least one substrate holder is arranged on the base stage and configured for rotating the substrate around a substrate rotation axis. In particular, the substrate holder is configured for rotating the substrate around a substrate rotation axis in such a way that the base stage rotation axis and the substrate rotation axis are inclined with respect to each other. The present invention also relates to an X-ray microscope for producing a magnified image of an object using X-rays.

Fig. 5

EP 4 477 777 A1

## Description

FIELD OF THE INVENTION

The present invention relates to a reactor and to a method for depositing one or more atomic layers of at least one material onto a substrate. Furthermore, the present invention relates to Fresnel zone plates and X-ray microscopes, comprising a Fresnel zone plate for producing a magnified image of an object using X-rays.

BACKGROUND OF THE INVENTION

It is known that focussing of X-rays with comparatively small focus lengths is generally difficult to achieve since in the photon energy range of X-rays, the complex refractive index $n = 1 - \delta - i\beta$ is close to one for all materials, where $\delta$ and $\beta$ describe the dispersion and absorption of the materials.

One way of focussing of X-rays with comparatively small focus lengths employs a diffractive optic, such as a Fresnel zone plate (FZP). A FZP is a concentric diffraction grating and comprises a set of alternating concentric rings, also called Fresnel zones or just zones, made of two different materials with different mass absorption coefficients and/or different phase shifts for the photon energy used. For high X-ray energies above 8 keV the phase shift of the X-rays due the choice of the two materials is the predominant factor for high diffraction efficiencies. Here, a differential phase shift between two adjacent zones close to 180° is desired. X-rays transmitted through the FZP experience diffraction. The period of zones varying across the FZP is selected such that the diffracted first order X-rays from an incoming parallel bundle of X-rays are all directed to a focus point. For the first diffraction order which is commonly used, the FZP acts as a thin lens that can form images of objects. In this full-field imaging mode, a sample object is placed between X-ray source and FZP. Alternatively, the FZP can be used as a focusing optic after the X-ray source but before a sample object with the sample object in the focus of the FZP. Scanning the sample object will also create an image with the resolution determined by the diameter of the focus spot of the FZP. This mode is referred to as Scanning Transmission X-ray microscopy (STXM). The radii of the individual Fresnel zones follow the zone plate law as described by Alexei N. Kurokhtin and Alexei V. Popov, "Simulation of high-resolution x-ray zone plates," J. Opt. Soc. Am. A 19, 315-324 (2002). The resolution of the FZP lens is predominately limited by and approximately equal to the width of the outermost zone, see, e.g., Y. Vladimirsky, D.P. Kern, T.H.P. Chang, D.T. Attwood, N. Iskander, S. Rothman, K. McQuaide, J. Kirz, H. Ade, I. McNulty, H. Rarback, D. Shu, Zone plate lenses for X-ray microscopy, Nuclear Instruments and Methods in Physics Research Section A: Accelerators, Spectrometers, Detectors and Associated Equipment, Volume 266, Issues 1-3, 1988, Pages 324-328, ISSN 0168-9002. For example, for achieving an X-ray imaging resolution of 50 nm by using its first diffraction order focus, the width of the outermost zone width must be less than 50 nm. To achieve a reasonable efficiency of FZPs, the height of the FZP, which is related to the zone height, should be optimized for each photon energy. Particularly, for high photon energies of more than 8 keV, FZPs with very high aspect ratios (ratio of height to width) for the outermost zones, typically of more than 100, are typically needed to achieve close to a 180 ° phase shift, depending on the materials used. For example, for a bi-layer system using Aluminium Oxide ($Al_2O_3$) and Zinc Oxide (ZnO) a FZP height, respectively zone height, of 36.33 $\mu$m is needed to achieve a differential phase shift of 180 ° at 17.5 keV. For 50 nm outermost zone width this translates into an aspect ratio of about 720.

Different approaches have been pursued for achieving high aspect ratios for the outermost zone of an FZP. For example, planar patterning processes known from the semiconductor industry, including e-beam lithography for nano-scale patterning and deep reactive ion etching for pattern transfer, allow fabricating FZPs with an aspect ratio of the outermost zones of 30 to 40. Yet, with such aspect ratios, the resulting FZPs are not applicable as X-ray lenses for photon energies of more than 8 keV for high resolution applications that require very high aspect ratios. Therefore, there is a pressing demand to find new methods for the fabrication of a FZP with high aspect ratio of the outermost zone such that the resulting FZP is suitable for focusing X-rays of 8 keV or more.

Moreover, manufacturing processes for FZPs have been proposed that are based on a bottom-up layer deposition process instead of a top-down (planar) patterning process. A bottom-up layer deposition process can be realised with atomic layer deposition (ALD) that represents a technology, which allows conformal coating of arbitrary substrates with atomic precision. For example, in WO 2011/054651 A1, a process for producing a FZP with ALD is described. The process comprises the provision of a substrate, which is rotationally symmetrical with respect to the central axis thereof; the deposition of successive layers by means of an ALD process to regions of the substrate without rotation of the substrate in order to form a coated substrate, and the separation of at least one disc from the coated substrate by dividing the coated substrate at least once perpendicular to the central axis. This traditional ALD process is on first hand limited to the very slow deposition rates, e.g. a 10 $\mu$m wide FZP layer stack would need a deposition time of 12 days or more, a 300 $\mu$m wide FZP, which is a more reasonable size for a practical X-ray imaging system, would take even a year are more to fabricate. Going to high-speed ALD cycles is problematic because the reduced dwell time of the precursors can lead to thickness variations, especially on the side opposite to the showerhead.

SUMMARY OF THE INVENTION

The present invention is based on the objective of providing an improved reactor and an improved method for depositing one or more atomic layers of at least one material onto a substrate with which practical FZPs for imaging applications at high photon energy >8 keV can be routinely manufactured. Furthermore, the present invention is based on the objective of providing an improved FZP for focusing X-rays of 8 keV or more as well as an improved X-ray microscope for producing a magnified image of an object using X-rays.

According to the invention, a reactor for depositing one or more atomic layers of at least one material onto a substrate is proposed. The reactor comprises a reaction chamber accommodating, a showerhead, a base stage and at least one substrate holder. The showerhead comprises at least one gas outlet that is configured for providing a gas stream of at least one precursor or reactant gas or of at least one component of at least one material. Preferably, with the showerhead, the gas stream may be provided continuously but may also be provided in a pulsed manner. The base stage is rotatable around a base stage rotation axis. Preferably, in operation of the reactor, the base stage may be rotated continuously but, alternatively, may also be moved in a stop and go fashion. The at least one substrate holder, which holds the substrate for deposition of the zones, is arranged on the base stage and configured for rotating the substrate around a substrate rotation axis. In particular, the substrate holder is configured for rotating the substrate around a substrate rotation axis in such a way that the base stage rotation axis and the substrate rotation axis are inclined with respect to each other, preferably, close to perpendicular to each other.

The present invention includes the recognition that ALD operates in the so-called ALD temperature window where the growth rate does not depend on the amount of introduced precursors, i.e. above a saturation threshold. As the precursor is introduced into the reaction chamber by pulses, a certain pulse duration is generally needed to achieve saturation. Thus, the growth is self-limiting, and the overall layer thickness, which corresponds later to the FZP zone width, typically depends only on the number of ALD cycles. Traditionally, each ALD cycle consists of four sub-cycles: precursor A pulse, purge gas pulse, precursor B pulse, purge gas pulse. Purge gas may also be mixed into the precursor. Purge gas pulses may also be implemented as a continuous gas stream over the duration of the full cycle. Thereby, the growth rate of traditional ALD, i.e. without rotation, is limited typically to about 1 Angstrom per cycle. This low growth rate results in a long deposition time for the layer stack needed for a FZP for practical use which requires tens of $\mu$m deposition thickness. With a realistic total cycle time of 10 seconds, a 10 $\mu$m stack would need a deposition time of about 12 days. Spatial ALD may provide growth rates in the range of ~1 nm (or more) per minute for flat substrates. In spatial ALD, the substrate is rotated beneath the individual now continuous instead of pulsed gas stream in a circular motion. Now the rotation frequency determines the pulse duration. The traditional ALD growth rate in growth per cycle (GPC) together with the rotation frequency can be rewritten as growth (nm) per time (min). Considering that one full rotation of the substrate under four individual gas streams (each gas stream being equal to one of the four traditional ALD sub-cycles) constitute one full ALD cycle, a growth rate of 1 nm/min with a 1 Angstrom per cycle growth rate would necessitate a rotation frequency of 0.16 Hz, e.g. 10 full rotations per 60 sec. Higher growth rates, i.e., higher rotation frequencies, typically reduce the dwell time under each precursor or reactant gas stream as well as beneath the purge gas stream. The result can be that the pulse time is below the saturation threshold, i.e. the minimum pulse time/dwell time, and, thus, outside the self-limiting growth regime. A small change in pulse time/-dwell time, by changing the rotation frequency, will generally change the growth rate. This may reduce the conformity of the deposition process on rotation-symmetric substrates, e.g., glass fibre or metal wire, which is needed achieving high aspect ratios of the outermost zone.

With the reactor according to the invention, it is possible to fabricate a FZP for focusing X-rays with an energy of 8 keV or more, i.e., a FZP having an aspect ratio of the outermost zone of the FZP of more than 100. In particular, with the reactor it is possible to fabricate a FZP by depositing the zones with given width values on a rotation-symmetric substrate. For example, on a circular substrate or core, alternating layers of a first material and a second material with different physical absorption and/or refraction properties can be deposited. A FZP for focusing X-rays with high photon energies fabricated with the reactor can have high aspect ratios, e.g., the FZP can have a width of several $\mu$m built of thin Fresnel zones, e.g., with an outer zone having a width of 50 nm or less. Especially, to achieve a targeted 10 nm resolution at X-ray energies of 8 keV or more an ALD reactor according to this invention is an enabling technology.

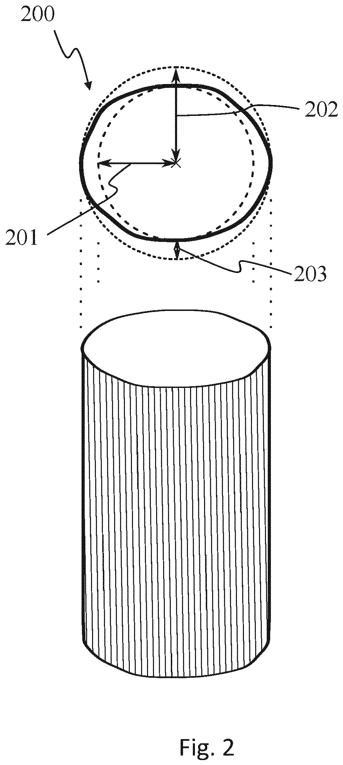

This is possible, since the reaction chamber is configured to provide a first, preferably continuous, rotation of base stage around the base stage rotation axis and, in addition, a second rotation of substrate holder around the substrate rotation axis. Accordingly, in the reaction chamber, a substrate held by the substrate holder is rotated directly by the substrate holder around the substrate rotation axis and indirectly by the base stage around the base stage rotation axis. An advantage of a rotatable base stage in combination with a rotatable substrate holder is that, in addition to a comparatively high deposition rate, a three-dimensional, cycle-controlled (cycle == rotation frequency controlled dwell time of the substrate under each preferably continuous gas stream) uniform deposition of atomic layers on a substrate is made possible, with a comparatively high layer thickness, which corresponds later to the zone width, accuracy and a low interface roughness for the final product and a low surface roughness during the fabrication process. In addition, to achieve the desired resolution, the substrate for the FZP is required to have a roundness with minimum $b - a = c \leq \frac{1}{2} w_N$ (cf. Figure 2, with 201 as a, 202 as b, and 203 as c) of the desired outermost zone width $w_N$ with a roughness in the same range. Here an interface roughness for the final product, e.g. a root mean square (RMS) of 0.5 nm, especially, for a zone width of the outermost zone of an FZP of 50 nm or less, and a layer width accuracy of $\Delta w(RMS)/w<0.01$, can be achieved.

Preferably, the substrate holder is configured to hold a substrate such as a glass fibre or a metal wire. Preferably, the substrate holder is arranged and configured to hold the substrate perpendicular to a gas stream direction of the gas stream provided by or being introduced through the gas outlet.

Preferably, the at least one substrate holder comprises a substrate holder driving mechanism that includes a motor and connected thereto a substrate mounting support for holding the substrate and rotating the substrate around a substrate rotation axis. The substrate rotation axis is thus defined as a property of the substrate holder and refers to a rotation axis around which a substrate held by the substrate holder can be rotated by the substrate holder.

Preferably, base stage and substrate holder are independently rotatable about their respective axes of rotation. For this purpose, a base stage drive mechanism and/or a substrate holder drive mechanism can be provided accordingly. The base stage drive mechanism and/or the substrate holder drive mechanism can comprise a servo motor, for example. Alternatively, the base stage drive mechanism and/or the substrate holder drive mechanism can comprise a printed circuit board (PCB) motor or a brushless (BL) motor. Preferably the substrate holder drive mechanism is implemented frictionless to minimize production of dust and particles. Furthermore, there can be a control unit for controlling the base stage drive mechanism and/or the substrate holder drive mechanism, i.e., in particular, for specifying a respective rotational speed. Control of the base stage drive mechanism and/or the substrate holder drive mechanism is accordingly possible independently of each other. Both drives are not coupled. However, alternatively, they may also be coupled.

In case there are two or more substrate holders present on the base stage, it is possible to control each substrate holder individually with one or more control units. For example, it is possible to provide a corresponding number of contact feedthroughs on the primary rotary feedthrough and to be able to control the individual motors of the substrate holders, e.g., if there is a sufficient number of motor controllers. Otherwise, it is possible to configure a control unit for controlling the substrate motors such that in operation of the reactor they rotate at the same frequency, e.g., all substrate motors run via the same controller. Alternatively, a rigid mechanical coupling to the base stage rotation axis is possible. The operative coupling between the base stage driving mechanism and the substrate holder driving mechanism may be realised via a gear system, preferably, a planetary gear system. The gear ratio can be chosen so that a full 360° movement around the substrate rotation axis for the substrate is realised, i.e., for one full rotation around the base stage rotation axis driven by a base stage driving mechanism may be four times one full rotation minimum to achieve homogeneity or even better 8 or even 16. In this case, the base stage driving mechanism, e.g., one main motor, would cause a rotation of the substrates via an appropriate transmission ratio. To change the frequency, generally, the gears on the substrate holders may be exchanged.

Additionally, or alternatively, the base stage comprises a base stage driving mechanism that is configured for rotating the base stage around a base stage rotation axis. Preferably, the at least one substrate holder comprises a substrate holder driving mechanism that is configured for rotating the substrate around a substrate rotation axis. Furthermore, preferably, the base stage driving mechanism and the substrate holder driving mechanism are operatively coupled such that a rotation provided by the base stage driving mechanism can be transferred to the substrate holder driving mechanism for rotating the substrate.

It is possible that the at least one substrate holder can be releasably mounted onto the base stage. For example, the substrate holder can have the form of a plate that is configured to hold the substrate and that can be pushed onto the base stage and snap into place there. There can be a mechanical coupling to realize the rotation of the substrate for example via a mechanical rotation coupling or preferably first through electrical contacts with the rotary motor on the substrate holder.

It is particularly preferred that the substrate holder is arranged and configured to rotate the substrate with the substrate rotation axis being substantially perpendicular to the base stage rotation axis. Such a reactor includes an additional rotation of the substrate via the one or more substrate holders with the substrate rotation axis perpendicular to a gas stream and along a central axis of the substrate. That means, in operation of the reactor, a substrate held in a substrate holder is rotated with the base stage rotation axis perpendicular to the rotation-symmetric substrate, e.g., a glass fibre or a metal wire, parallel to a gas stream and around a substrate rotation axis of the substrate with the substrate rotation axis parallel to the substrate's longitudinal axis. The substrate may be mounted on the substrate holder which then allows for the additional rotation around the substrate rotation axis, and being placed on the main base stage, which at the same time can be rotated around the base stage rotation axis. Accordingly, in addition or as an alternative, it is further preferred that the substrate holder is arranged and configured to rotate the substrate with the substrate rotation axis being substantially perpendicular to a gas stream direction that is predefined by the at least one gas outlet and along which the gas stream is provided. Furthermore, additionally or alternatively, it is preferred that the base stage is arranged and configured to be rotatable with the base stage rotation axis being parallel to a gas stream direction that is predefined by the at least one gas outlet and along which the gas stream is provided. Preferably, the gas outlet is configured to introduce the gas stream into the reaction chamber along the gas stream direction.

Preferably, the reaction chamber comprises a base stage heating element with which the base stage can be heated. Additionally, or alternatively, the reaction chamber may comprise a radiation source for providing infrared radiation. The radiation source may be configured and arranged to provide infrared radiation heating spots so that a substrate held by the substrate holder can be heated in spatially localized areas. In the reaction chamber, it is thus possible to provide direct heating of a substrate by means of the base stage heating element and/or indirect heating by means of a radiation source. A radiation source can be located outside the reaction chamber. In that case, the reaction chamber may comprise a window transparent for infrared radiation provided by the radiation source. Alternatively, a radiation source can be located inside the reaction chamber. This has the advantage that the gas flow dynamics may not be influenced by an opening or flanges for the transparent window as it could be the case when having a window in the reaction chamber wall. Heater assemblies inside the reaction chamber may be streamlined.

It is preferred that the reaction chamber comprises a substrate holder heating element(s) arranged and adapted to heat the at least one substrate holder. Additionally, or alternatively, each removable substrate holder has its own heating element. Providing a substrate holder heating element has the advantage that a deposition, e.g., at other places, by appropriate temperature which is outside the ALD temperature window can be minimized. Moreover, with this it is possible to avoid (or to reduce) flakes caused by flaking of the coating on walls or other components inside the reaction chamber, that can unintentionally accumulate on the substrates.

Preferably, the reaction chamber comprises a plurality of substrate holders arranged on the base stage, wherein each of the plurality of substrate holders is independently rotatable relative to the base stage about a respective substrate rotation axis. The multiple substrate holders are preferably arranged along a circle on the base stage.

Preferably, the showerhead is divided into four sections, and wherein in a first section there is a first gas outlet for providing a first gas stream comprising a first precursor or reactant gas to be deposited and/or at least one component of the to be deposited material, in a second section there is a second gas outlet for introducing a first purge gas, in a third section there is a third gas outlet for providing a second gas stream comprising a second precursor or reactant gas to be deposited and/or at least one component of the to be deposited material, and in a fourth section there is a fourth gas outlet for introducing a second purge gas. The first and second purge gases can be of the same composition. The purge gas can be a non-reacted gas, e.g. an inert gas such as argon. There may be a small vacuum (or purge gas or curtain gas) section between the individual sections. This may help to avoid gas mixing. If necessary, this vacuum section may also supply purging gas instead of vacuum, so it may be switchable between vacuum or purge gas. Preferably, the first and third sections and the second and fourth sections are opposite each other so that one of the second and fourth sections is located between the first and third sections in both directions. Preferably the gas streams of each segment are introduced continuously. Additionally, or alternatively, the respective gases can be introduced cyclically or pulsed one after the other, with each first and second gases being a purge gas for a purge step. Preferably, the cycle and pulse time, of the introduced gases, is synchronized with the base stage rotation frequency.

The first gas stream and the third gas stream can each include a carrier gas. The carrier gas preferably contains precursors or reactant gas which itself contains the material to be deposited or a respective component thereof.

The reactor preferably comprises a control unit for controlling at least one deposition parameter based on a sensor signal provided by a sensor. A measurement sensor may be, for example, a quartz microbalance, a reflectance measurement sensor, reflectance anisotropy spectroscopy (RAS) sensor, or single wavelength or spectroscopic ellipsometry sensor. Accordingly, it is possible to include an adaptive control of the deposition parameters, e.g. based on a sensor input.

It is possible that the showerhead sections are further subdivided into circular/arc segments which can be individually switched off, switched to purging gas or switched to vacuum. Subdividing the segments is preferred above the substrate, e.g., in the area of the substrate holder. For a substrate, e.g., a fibre, having a length of 1 cm, a subdivision in the radius of $r <= x <= r + 1$ cm may be sufficient with the substrate fibre placed below the $r <= x <= r + 1$ cm segments. The remaining segments smaller than r and larger than r + 1 cm may also be addressed in the same way as comparatively larger sub-segments to provide purging and deposition on the substrate ends. This is also true for substrates that are longer or shorter than 1 cm. The upper limit of the length of the substrate may be given by half of the diameter of the base stage. For pattering purposes, a sub-segment radial diameter may be as small as possible, may be uniform for all segments, but may also have variable diameter, e.g., for a fixed deposition process and a FZP product. The upper diameter should be given by 1200 dpi, e.g., about 20 $\mu$m radial diameter which is a typical inkjet nozzle size, but preferably equal or below 1 $\mu$m. For a 1 cm long substrate and 1 $\mu$m sub-segment size, about 10000 segments may be advantageous. Preferably, the reactor is configured such that in operation, those segments that are not used for introducing a gas stream can be switched either to purging gas or to vacuum. This is advantageous to achieve the desired patterning effect.

Preferably, the reactor comprises a distance adjustment unit that is configured to adjust a distance between the base stage and the showerhead. The distance between the base stage and the showerhead may be adjusted with the distance adjustment unit during a deposition of one or more atomic layers of the at least one material for layer formation on the substrate. For example, the distance adjustment unit can be controlled by a control unit with a minimum distance by direct contact of the showerhead with the substrate holder and maximum distance with full retraction of the showerhead into the upper half of the reaction chamber, preferably, greater than or equal to the diameter of the base stage. Additionally, or alternatively, the base stage and substrate holders can be moved up and down.

The present invention also relates to a method of depositing one or more atomic layers of at least one material onto a substrate by means of a reactor as described herein. The method comprises the steps of:

- arranging the substrate on the at least one substrate holder,

- arranging the substrate holder with the substrate on the base stage in the reaction chamber,

- introducing the gas stream comprising the at least one material and/or at least one component of the at least one material through the at least one gas outlet into the reaction chamber,

- rotating the substrate about the base stage rotation axis with the base stage and additionally rotating the substrate about the substrate rotation axis with the substrate holder, the base stage rotation axis and the substrate rotation axis being inclined to each other, and

- depositing one or more atomic layers of the at least one material and/or the at least one component of the at least one material on the substrate.

In the method, it is preferred that the substrate is a glass fibre or a metal wire.

In the method it is preferred that alternating layers of a first material and a second material are deposited onto the substrate in the form of concentric rings with controlled width, the first material and the second material differing in at least one physical property. A physical property may be an absorption property, a dispersive property, especially for X-rays, and residual stress in the layer materials or thermal expansion of the materials used. The first material and the second material may be e.g. one of an oxide, a nitride, a silicide, a carbide, and a metal. It is preferred that the first material shall have sufficient contrast to the substrate as well as to the second material for X-rays in a given photon energy range. That is, with the index of refraction of a material given by n = (1-$\delta$)-i*$\beta$ with $\delta$ and $\beta$ describing dispersion and absorption, respectively. For sufficient contrast, here the difference in $\delta$ and $\beta$ between the two materials should be greater than $\Delta\delta > 1E^{-9}$ and $\Delta\beta > 1E^{-10}$ for X-rays with an energy of 8 keV or more. Accordingly, the difference in the complex index of refraction between the first and the second material has to be sufficiently large to achieve high focusing efficiency.

At least one material preferably should have self-smoothing properties during the deposition of, preferably $Al_2O_3$. A self-smoothing material is any material (or precursor in an ALD deposition process) for which the surface roughness is decreases during the deposition process, e.g., the final surface roughness of the deposited material is lower than the surface roughness of the substrate or the material it is deposited, e.g., the RMS roughness is reduced from 3.3 nm to 1.5 nm as described by Myers et. al, " Smoothing surface roughness using Al2O3 atomic layer deposition," Applied Surface Science 569, 150878 (2021).

Both materials preferably should be compatible to each other and to the substrate, e.g., they should exhibit good adhesion (bonding to the underlying material) as well as low residual stress, which can lead to cracking and delayering.

Preferably, in the method, the width and the number of zones are selected according to Fresnel's zone plate law ("A. J. Fresnel, "Calcul de l'intensité de la lumière au centre de l'ombre d'un ecran et d'une ouverture circulaires eclairés par un point radieux", in: Œuvres Complètes d'Augustin Fresnel, Imprimerie Impériale, Paris, 1866") and controlled by adjusting the deposition parameters.

Preferably, in the method, the at least one material is deposited at a deposition rate of 1 nm per minute or more, preferably, of 10 nm per minute or more. This is equal to 0.16 Hz or 1.6 Hz rotation frequency of the base stage for a typical 1 Angstrom per cycle growth rate.

Preferably, the method comprises cleaning the substrate prior to or after arranging the substrate holder with the substrate on the base stage in the reaction chamber or a suitable pre-chamber (transfer chamber) by means of a $CO_2$ snow gun, ozone source/generator, a plasma source, e.g., Argon, Nitrogen, Hydrogen, Oxygen, by means of sputtering, e.g., using Argon, Nitrogen, Helium or cluster source, e.g. C60, or etching, for example, reactive ion etching with e.g. $CF_4$/Ar. Alternatively or additionally, gas streams from the ALD shower head can be used for substrate cleaning. The cleaning step may be used to remove debris, dirt, and imperfections to arrive at a substrate which is free of foreign substances below a contamination (particle) density of less than $1*E6/cm^2$, preferably less than $1*E4/cm^2$ after processing. However, preferably, the cleaning procedure does not increase the surface roughness or the increase the roundness of the substrate, e.g., the roundness with a minimum

$$b - a = c \leq \frac{1}{2} w_N$$

(cf. Figure 2) of the outermost zone width $w_N$ with a roughness in the same range.

The methods may include a step of performing a surface termination or of performing a surface functionalization. Creating a surface termination or surface functionalization in particular for an ALD process may be accomplished using, e.g., OH groups, in particular, for oxide deposition, C groups, in particular, for carbide deposition, or NH groups, in particular, for nitride deposition.

The present invention is further directed to a use of the reactor described herein for producing the FZP.

Preferably, the FZP produced with the reactor comprises a first material and a second material arranged alternately in a sequence of concentric rings following Fresnel's zone plate law on a substrate. The FZP preferably has an aspect ratio, defined as the ratio of the height of the zone to the width of the outermost zone, of 50 or more and an outermost zone with a zone width of 50 nm or less. Preferably, the FZP has a surface and/or interface roughness of 0.5 nm or less. Optionally, the FZP may have a zone width accuracy $\Delta w(RMS)/w$ of 0.01 or less and, preferably, a zone width of at least 0.2 nm, an

$$R \geq 1 - \frac{\frac{1}{2} \cdot w_N}{b}$$

roundness of the respective zones of
or more, where $w_N$ denotes the width of the outermost zone, and/or an aspect ratio of the outermost zone of 50 or more. Preferably, $w_N$ is 50 nm or less.

Furthermore, the present invention relates to an X-ray microscope for producing a magnified image of an object using X-rays. The X-ray microscope comprises an X-ray source, a first X-ray optic, a sample object stage, a second X-ray optic, an X-ray imaging detector, and a control unit. Additionally, pinholes and apertures may be utilized as needed. The X-ray detector is configured for detecting X-rays provided by an Xray source and penetrating the object. The first X-ray optic is used for collimating X-rays for illumination of the sample object and can be automatically moved into and out of an X-ray beam path between the X-ray source and the object. The second X-ray optic is the FZP can be automatically moved into and out of an X-ray beam path between the object and the X-ray detector. Preferably, the FZP used as the second X-ray optic comprises a first material and a second material arranged alternately in a sequence of concentric rings following Fresnel's zone plate law on a substrate. The FZP preferably has an aspect ratio, defined as the ratio of the height of the zone to the width of the outermost zone, of 50 or more and an outermost zone with a zone width of 50 nm or less. Preferably, the FZP has a surface and/or interface roughness of 0.5 nm or less. Optionally, the FZP may have a zone width accuracy $\Delta w(RMS)/w$ of 0.01 or less a roundness of the respective

$$R \geq 1 - \frac{\frac{1}{2} \cdot w_N}{b}$$

zones of or more, where $w_N$ denotes the width of the outermost zone, and/or an aspect ratio of the outermost zone of 50 or more. Preferably, $w_N$ is 50 nm or less. The FZP used as the second X-ray optic preferably is fabricated using the reactor and the method described herein.

The control unit is configured for controlling the automatic movements of the first X-ray optic and the second X-ray optic into and out of the beam path. Moreover, the control unit is configured for aligning the first X-ray optic and the second X-ray optic with respect to the beam path, e.g., an interferometric or capacitive alignment system.

The X-ray microscope can be operated in two different modes, in a micro X-ray imaging mode and in a nano X-ray imaging mode. In the micro X-ray imaging mode, an image of the object can be recorded with micrometre resolution. To this end, the control unit is configured for moving the first X-ray optic and the second X-ray optic out of the beam path. In the nano X-ray imaging mode, an image of the object can be produced with nanometre resolution. For recording an image of the object with nanometre resolution, the control unit is configured for moving the first X-ray optic and the second X-ray optic into the beam path. The combination of the micro X-ray and nano X-ray imaging mode is enabled by the FZP for high energy X-rays that have enough penetration power to allow micro X-ray imaging. Preferably, nanometre resolution refers to a resolution of 100 nm or less. Preferably, micrometre resolution refers to a resolution of 5 $\mu$m or less, e.g., of more than 100 nm to 5 $\mu$m.

Nano-XCT has typically a resolution of 100 nm or less (e.g. limited by the outermost zone width of the FZP), micro XCT of 5 $\mu$m or less (e.g. limited by the spot size of the X-ray source and resolution of the X-ray detector).

In the micro X-ray imaging mode and in the nano X-ray imaging mode, the X-ray microscope can record a plurality of 2D images of the sample object, e.g., at different spatial orientations by rotating the sample object under investigation in between images. From a set of recorded 2D images, a 3D reconstruction of the object can be computed, e.g., employing an image processing unit. Accordingly, in the micro X-ray imaging mode, a plurality of images of the object can be recorded with micrometre resolution and a 3D reconstruction with micrometre Voxel size can be computed from a set of 2D images. Correspondingly, in the nano X-ray imaging mode, a plurality of images of the object can be recorded with nanometre resolution and a 3D reconstruction with nanometre Voxel size can be computed from a set of 2D images.

Preferably, the first X-ray optic can be moved automatically and reproducibly into and out of an X-ray beam path between the X-ray source and the object. Preferably, the second X-ray optic can be automatically and reproducibly moved into and out of an X-ray beam path between the object and the X-ray detector. Herein, reproducibly means an accuracy of 1 μm or less for rough and 100 nm or less for fine linear alignment. Angular alignment accuracy needs to be 10 urad or better, preferably 1 urad. In particular, the control unit is configured for controlling the automatic and reproducible movements of the first X-ray optic and the second X-ray optic into and out of the beam path, respectively.

The present invention includes the further recognition that so far, known nano-scale X-ray microscopes with a resolution of about 50 nm have not been adopted widely in industry because of limited object penetration and need for extensive sample object preparation. The thickness of sample objects is limited to tens of micrometres or less depending on the material and type of microscope. As an example, sample objects for imaging with a known X-ray microscope, operated at 8 keV, have to have a thickness of about 100 μm, depending on the composition. In many cases, e.g. sample objects made out of silicon or metals, the sample object thickness has to be even less than 100 μm. That means photons with this energy cannot transmit through a 780 μm thick Silicon wafer. For real industrial products such as highly integrated microchips, chiplets and packaged chips, it is necessary to use cutting, polishing and/or de-processing techniques to reach nano-scale imaging conditions. For batteries, it is even necessary to produce special miniaturized test cells that are very different from the actual batteries to fulfil imaging requirements. This preparation process is often difficult and time-consuming.

Moreover, existing systems are generally limited by the X-ray lenses they use and operate only at very low X-ray energy that does not have the penetration power for thick objects. However, at high X-ray energies, which allow for deep object penetration nanometre resolution is only possible with specialized optical elements.

The X-ray microscope according to the present invention overcomes these drawbacks and accepts relevant sample objects directly without extensive preparation, offers assisted navigation to the region of interest and nano-scale imaging in a seamless solution to make it suitable for industry adoption. Moreover, the X-ray microscope can be operated at a monochromatic high X-ray energy of 8 keV or more, e.g., Molybdenum Kα at 17.5 keV, Rhodium Kα at 20.2 keV or Indium Kα at 24.2 keV, and has a high-power X-ray source to penetrate thick objects, e.g., using a solid-anode, microfocus anode, rotating anode, or a regenerative target, e.g., a metal band or liquid metal jet X-ray source, excited by electrons conventionally or with a laser-induced plasma. With the second X-ray optic being the FZP according to the present invention, it is possible to maintain the object penetration and at the same time to generate nano-scale resolution images which constitutes a paradigm change in X-ray microscopy. Without using the X-ray optics, the X-ray microscope can obtain micro-scale 2D imaging to navigate on the sample object and generate 3D lower resolution overview reconstruction of the sample object.

The transition between the micro X-ray imaging mode and the nano X-ray imaging mode may be seamless and transparent to the user without sample object shuttle to another tool and without navigation procedures. For the transition from the projection based (lens-less) micro X-ray imaging mode to the nano X-ray imaging mode, two X-ray optics are inserted into the beam path. No further manual adjustment or alignment may be needed, except for initial pre-set alignment. Adjustments due to. E.g., mechanical or thermal instabilities may be handled autonomous in software and hardware, for example, using a respectively trained artificial neural network for assisted alignment, or closed loop sensor-based alignment, e.g. an interferometric, capacitive, or image sensor based alignment system.

Preferably, the first X-ray optic is configured to focus the light from the X-ray source onto a small area of the sample object to be imaged (condenser illumination optic). It also preferably filters the photon energy spectrum from the X-ray source to put as much X-ray flux into the characteristic emission line of the X-ray source. The first X-ray optic preferably is an elliptically shaped single reflection capillary that preferably is coated on the reflecting surface with a suitable material, or a focusing multilayer monochromator. Preferably, the X-ray microscope comprises a positioning system that is arranged and configured for guiding a transition from the micro X-ray imaging mode to the nano X-ray imaging mode and *vice versa*. The positioning system may comprise the control unit. Preferably, the control unit comprises an artificial neural network that is trained for aligning the first X-ray optic and the second X-ray optic with respect to the beam path for producing the image of the object with nanometre resolution using sensor data from the microscope as input.

It shall be understood that the aspects described above, and specifically the reactor of claim 1, the method of claim 9 and the X-ray microscope of claim 14 have similar and/or identical preferred embodiments, in particular as defined in the dependent claims.

It shall be understood that a preferred embodiment of the invention can also be any combination of the dependent claims or above embodiments with the respective independent claim.

These and other aspects of the invention will be apparent from and elucidated with reference to the embodiments described hereinafter.

## BRIEF DESCRIPTION OF THE DRAWINGS

Fig. 1     schematically and exemplary shows a Fresnel zone plate in a top view and in a cross-sectional view;

Fig. 2     schematically and exemplary shows a round core substrate in a top view and in a three-dimensional view with low roundness;

Fig. 3     schematically and exemplary shows in a three-dimensional view a core substrate with a cylindrical shape and a core substrate with a tapered shape;

Fig. 4     schematically and exemplary shows in different views a substrate holder with mounted substrate, the substrate holder brackets with electrical contacts of the substrate holder, that part of the substrate holder that holds and, in operation, rotates the substrate;

Fig. 5     schematically and exemplary shows a base stage and arranged on the base stage a plurality of substrate holders each holding a substrate and in a cross-sectional view a showerhead arranged above the base stage having the substrate holders with substrates arranged on it;

Fig. 6     schematically and exemplary shows an underside of the showerhead that is divided into four segments and the underside of the showerhead wherein the precursor segments are further sub-divided into arc-shaped segments of identical radial width;

Fig. 7     schematically and exemplary shows an underside of the showerhead that is divided into four segments wherein the precursor segments within an intermediate area are further sub-divided into arc-shaped segments of identical radial width, the most outer segment and the most inner segment having a larger radial width than the segments in the intermediate area;

Fig. 8     schematically and exemplary shows a sections of a showerhead in a sectional view that is configured for applying a precursor onto a rotating substrate, or is sub-divided into a plurality of arc-shaped segments for alternately applying a precursor and a gas or exhaust onto a rotating substrate or is sub-divided into two arc-shaped segments one of which is configured for apply a precursor and the other one being configured for applying a gas or exhaust onto a rotating substrate;

Fig. 9     schematically and exemplary shows a block diagram of a reactor for depositing one or more atomic layers of at least one material onto a substrate; and

Fig. 10     schematically and exemplary shows in a) those components of an X-ray microscope that participate in the generation of a sub-micrometre resolution image of an object in the micro X-ray imaging mode and in b) those components of an X-ray microscope that participate in the generation of a nanometre resolution image of an object in the nano X-ray imaging mode.

## DETAILED DESCRIPTION OF EMBODIMENTS

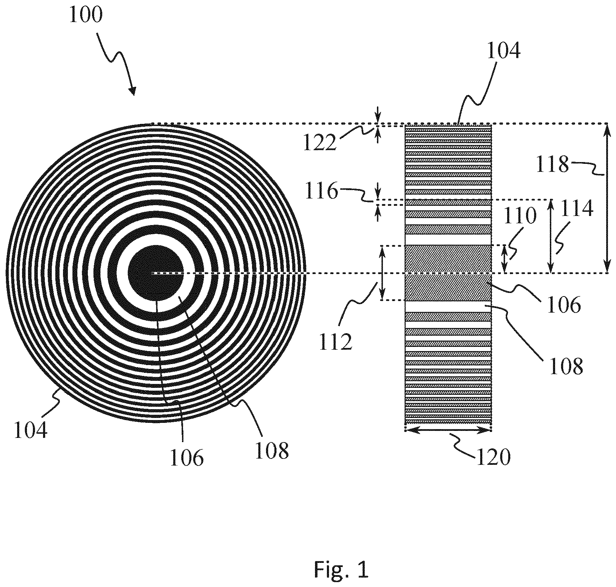

Figure 1 schematically and exemplary shows a FZP 100, in a front view and in a sectional view. The radius of the n-th zone is given by 114 ($r_n$). The n-th zone has a width of 116 ($w_n$). The height of the zones and the height of the FZP 100 is given by 120. The radius, diameter, and the height of the first zone 106 are 110, 112 and 120, respectively. The radius and the width of the outermost zone 104 (N-th zone) are 118 ($r_N$) and 122 ($w_N$). The FZP 100 comprises a first material 106 (black circles in front view, hatched in cross sectional view) and a second material or void 108 (white circles) arranged alternately in a sequence of concentric rings following Fresnel's zone plate law. Preferably, the first material 106 is a high-density material that is absorbing and strongly phase shifting for X-rays at about 8 keV or higher and the second material is less dense, more transparent and weakly phase shifting for high energy X-rays at of about 8 keV and higher. X-rays will then get diffracted by the alternating zones 106 and 108 and so on. The period of zones 106, 108 are spaced along the radius of the FZP so that diffracted X-rays with a specific energy from a parallel X-ray bundle constructively interfere at a predefined focus on the optical axis. The FZP acts like a lens for X-rays of a single energy, and therefore, it can produce X-ray images by using the FZP in an imaging arrangement.

The FZP 100 can be used to focus X-rays, e.g., with a photon energy of 8 keV or more. This is possible since the FZP 100 has an aspect ratio of an outermost zone 104 of 650 or more and an outermost zone 104 with a zone width $w_N$ of 30 nm or less. In other embodiments, the FZP 100 has an outermost zone 104 aspect ratio of 400 or more and an outermost zone 104 with a zone width $w_N$ of 50 nm or less. Moreover, the FZP 100 has a layer width accuracy $\Delta w(RMS)/w$ of 0.01 but may have in other embodiments a layer width accuracy of $\Delta w(RMS)/w < 0.01$. Furthermore, the FZP 100 has a roundness R of the respective zones with $b - a = c = \frac{1}{2} w_N$, but may also have a roundness of the respective zones of with $b - a = c \leq \frac{1}{2}$

$w_N$.

Figure 2 schematically and exemplary shows a round core substrate 200 in a top view and in a three-dimensional view with 202 as the radius **b** of the circumscribed circle and 201 as the radius **a** of the inscribed circle. The roundness R is defined as

$$R = \frac{a}{b}.$$

A large roundness means that the roundness is as close to one (perfect circle) as possible, i.e., the difference between circumscribed and inscribed circle radius 203 (b-a) is preferably less than 100 nm with

$$0 \leq b - a = c \leq \frac{1}{2} \cdot w_N$$

R is at least or greater than

$$R = \frac{a}{b} = \frac{b-c}{b} \geq \frac{b - \frac{1}{2} \cdot w_N}{b} = 1 - \frac{\frac{1}{2} \cdot w_N}{b}$$

with $w_N$ denoting the width of the outermost Zone 104 cf. Fig. 1.

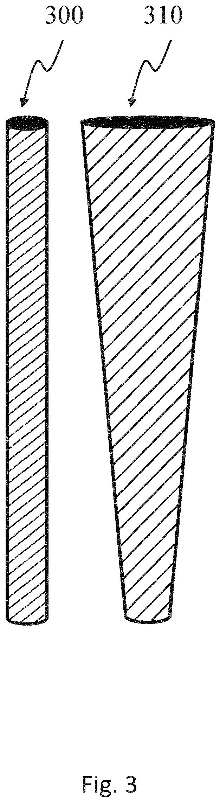

Figure 3 schematically and exemplary shows in a three-dimensional view a core substrate 300 with a cylindrical shape, and a core substrate 310 with a tapered shape, including but not exclusively linear, parabolic, and curved tapers. The substrates 300 and 310 may have a large roundness, including two-dimensional roundness $\hat{R}$, as the substrate 200 described with reference to figure 2. The two-dimensional roundness $\hat{R}$ can be calculated for different slices along the fibre according to

$$\hat{R} = \frac{1}{N} \sum_{i=1}^{N} R_i$$

with $R_i$ as the roundness, as described above as the ratio of radius $a_i$ of the inscribed circle to the radius $b_i$ of the circumscribed circle for one cross-sectional slice I along the main substrate axis.

Substrates that are tapered, e.g. linear or parabolic change of diameter along the main axis, can provide higher diffraction efficiencies, as described by Sanli et. al, "3D Nanoprinted Plastic Kinoform X-Ray Optics," Advanced Materials 30, 1802503 (2018).

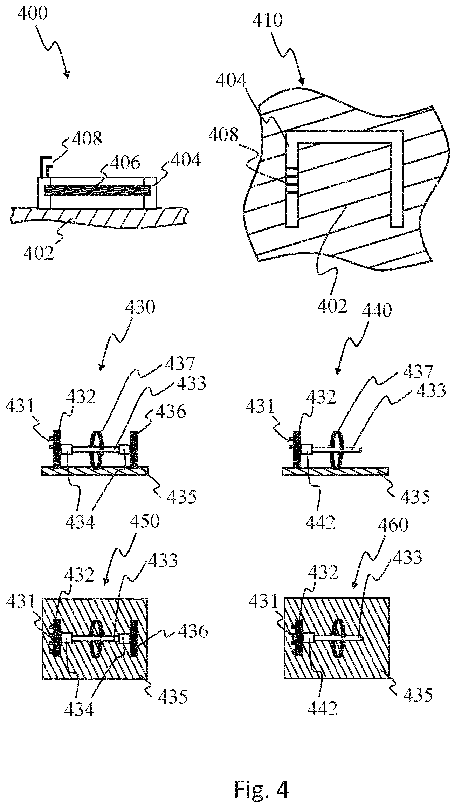

Figure 4 schematically and exemplary shows, a substrate holder split into two parts with the stationary substrate holder mounting mechanism part in a cross-sectional view 400 and in a top-view 410 on the base stage 402, the retaining bracket 404 with a groove 406 to accept the removable substrate holder shown in views 430, 450 or 440, 460 and with electrical contacts 408 for the removable substrate holder part. The removable substrate holder part in a cross-sectional view 430 and top-view 450 holds and in operation rotates a substrate 433 with a substrate rotation retainer 434 on both ends of the substrate on a removable substrate holder plate 435. The substrate rotation retainer 434 is mounted with one side to a bearing 436 and with the opposite side, the retainer 434 is mounted to a substrate holder drive mechanism implemented as a rotary drive 432 with electrical contacts 431. The rotary drive 432 is configured for rotating the substrate 433 around a substrate rotation axis 437. Preferably the rotary drive is hermetically sealed to avoid generation of particles.

The removable substrate holder part in a cross-sectional view 440 and top-view 460 holds and in operation rotates a substrate 433 with a substrate rotation retainer 442 on one end of the substrate on a removable substrate holder plate 435. The substrate rotation retainer 442 is mounted to a substrate holder drive mechanism implemented as a rotary drive 432 with electrical contacts 431. The rotary drive 432 is configured for rotating the substrate 433 around a substrate rotation axis 437.

The substrate 433 may be configured as one of the substrates 300, 310, 320, or 330 described with reference to figure 3.

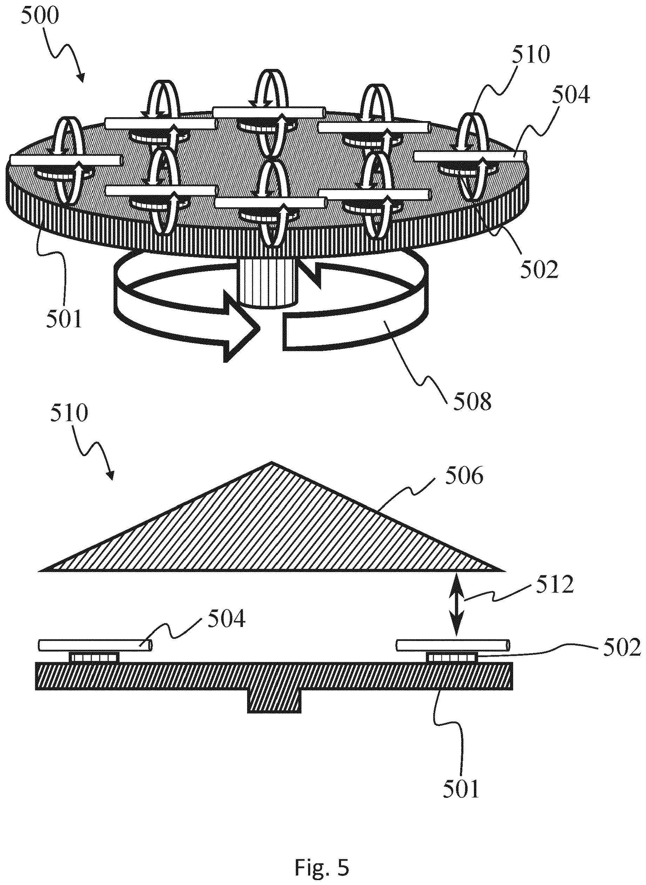

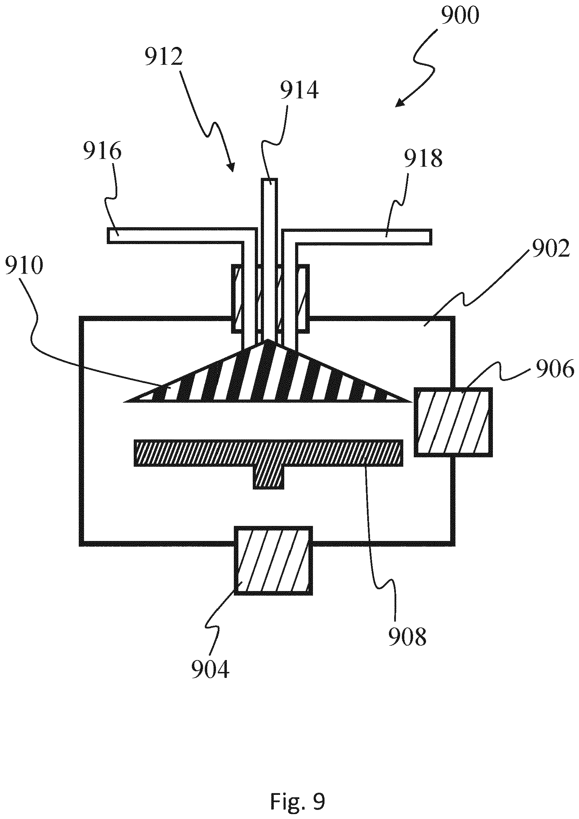

The substrate holder system described with reference to figure 4 may be used, e.g. as the substrate holder 502 described with reference to figure 5 and in combination with the reactor 900 described with reference to figure 9.

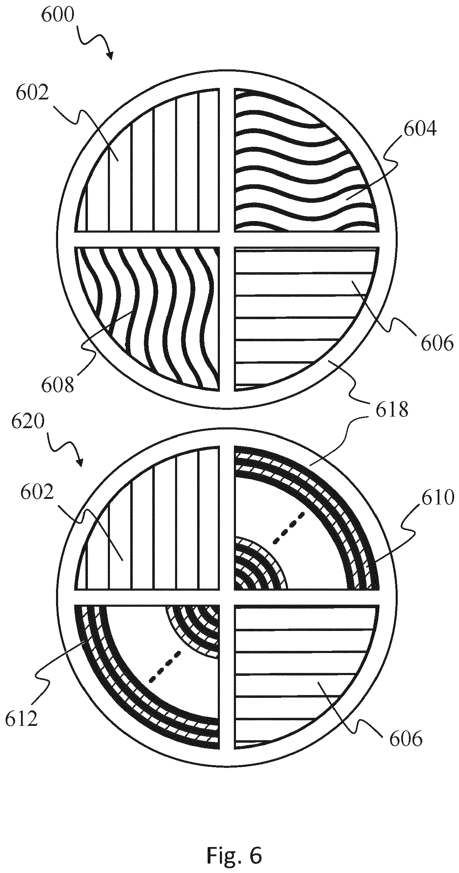

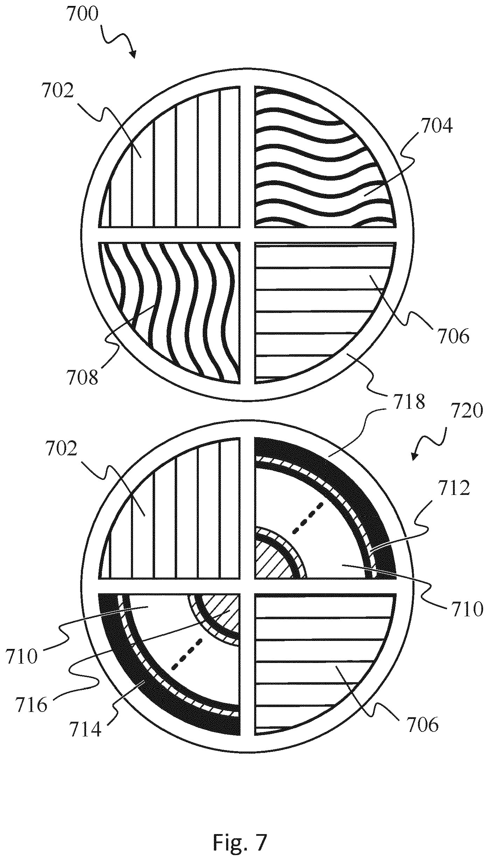

Figure 5 schematically and exemplary shows a three-dimensional view 500 of a base stage 501 and arranged on the base stage 501, a plurality of substrate holders 502 each holding a substrate 504. In a cross-sectional view 510 a showerhead 506 arranged above the base stage 501 having the substrate holders 502 with substrates 504 arranged on it. The showerhead 506 may be configured like the showerheads 600 and 700 described with reference to figures 6 and 7, respectively.

The base stage 501 can be rotated around a base stage rotation axis 508. Substrates 504 are mounted on the substrate holders 502, which are arranged in a circular pattern on the base stage 501. The substrates 504 can be rotated around a substrate rotation axis 510 by the respective substrate holders 502. The substrate rotation axis 510 is perpendicular to the base stage rotation axis 508 as well as to the gas and precursor stream from the showerhead 506. The precursor and gas delivering showerhead 506 is positioned above the substrates 504 and the base stage 501 with a variable distance of d 512. For adjusting the distance d 512, an optional distance adjustment unit may be present.

Figure 6 schematically and exemplary shows an underside of the showerhead 600 that is divided into four segments 602, 604, 606, 608 and the underside of a variant 620 of the showerhead 600, wherein the two precursor or reaction gas segments 602 and 604 are further sub-divided into arc-shaped segments 610 and 612 of identical radial width. Each of the segment 602, 604, 606, 608 is connected to its own delivery line for gases, or precursors, respectively. Gas and precursor delivery is controlled via a gas and/or precursor mixing manifold of the showerhead 600. There may be a small vacuum (or purge gas or curtain gas) section 618 between the individual sections 602, 604, 606, 608. With the four segments 602, 604, 606, 608 it is possible to provide a precursor or purge gas stream to a substrate underneath with a continuous, pulsed or timely varying flowrate. In particular, a purge gas stream and precursors are applied in neighbouring sections, e.g. in a first segment 602 and a third segment 606 a purge gas can be provided and in a second segment 604 and in a fourth segment 608, two different precursors, e.g., in the second segment 604 an organic or inorganic precursor for oxides, metals, or nitrides can be provided and the fourth segment 608, an oxidizer, hydrogen plasma, or a nitrogen precursor, e.g., ammonia, nitrogen gas, nitrogen plasma can be provided to deposit oxides, metal, or nitrides.

Moreover, each of the segments 602, 604, 606, 608 is surrounded by a trench 618 to avoid mixing of neighbouring chemicals, which is connected to the exhaust (vacuum) or a purge gas to provide a barrier between the segments 602, 604, 606, 608. The two segments 602 and 606 are configured for providing a gas A and the same or a different gas B, respectively, e.g., in an ALD process.

Additionally, for a variant of the showerhead 620 segment 604 for precursor A delivery and segment 608 for precursor B delivery can be further divided into n arc-shaped sub-segments 610 and 612 with constant radial width, shown as alternating arc-shaped black and hatched quarter rings. Each individual arc-shaped sub-segment 610 (for segment 604) and 612 (for segment 608) can be individually controlled and switched to gas, precursor or exhaust. This provides rotation symmetric pattering and/or deposition of a substrate held by a substrate holder, e.g., as described with reference to figure 4.

Figure 7 schematically and exemplary shows the underside of the showerhead 700 that is divided into four segments 702, 704, 706, 708 and the underside of the showerhead 720, wherein the precursor segments 704, 708 of the showerhead 700 within an intermediate area 710 are further sub-divided into arc-shaped sub-segments 712 of identical radial width. The most outer segment 714 and the most inner segment 716 have a larger radial width than the segments 712 in the intermediate area 710. There may be a small vacuum (or purge gas or curtain gas) section 718 between the individual sections 702, 704, 706, 708.

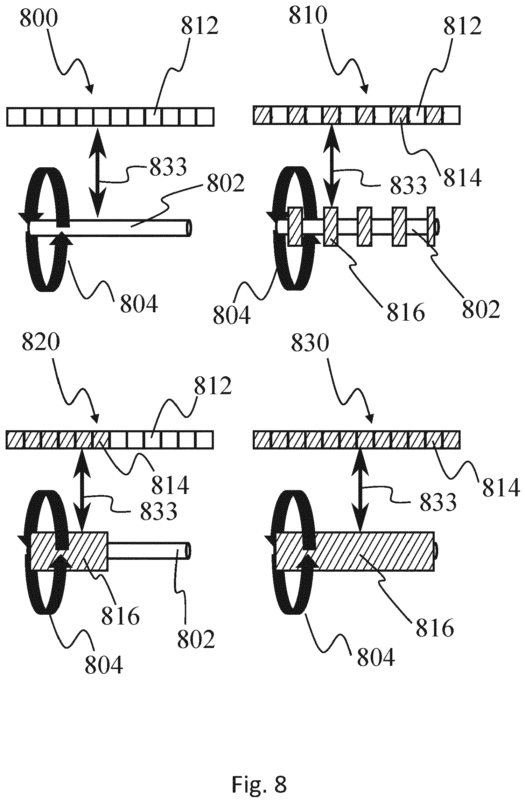

Figure 8 schematically and exemplary shows a section of a showerhead 800, 810, 820 and 830 in a sectional view that is configured for applying a precursor onto a rotating substrate 802. The showerhead 800, 810, 820 and 830 is sub-divided into a plurality of arc-shaped segments for alternately applying a precursor 814, and a gas or exhaust 812 onto a rotating 804 substrate 802. As shown at the example of figure 8, when having sections of the showerhead sub-divided into arc-shaped segments, the functionality on the lateral deposition can be changed in a controllable manner. For example, by varying an arc segment functionality over time and/or a substrate-to-showerhead distance 833 (d), various different width profiles 816 of concentric rings, e.g., zones of a FZP can be realized.

Figure 9 schematically and exemplary shows a block diagram of a reactor 900 for depositing one or more atomic layers of at least one material onto a substrate, e.g., for fabricating a FZP as described with reference to figure 1. For example, the reactor 900 can be operated to conduct an ALD process. To this end, the reactor 900 comprises a reaction chamber 902, an exhaust vacuum pump 904, a load lock 906 and arranged in the reaction chamber 902, a base stage 908 and a showerhead 910. The base stage can be configured as described with reference to figure 5 and comprises one or more substrate holders as described with reference to figures 4 and/or 5. The showerhead 910, preferably, is configured as the showerheads 600, 620, 700 or 720 as described with reference to figures 6 and 7, respectively. The reactor 900 further comprises a gas and precursor manifold inlet 912 comprising a connection to a vacuum pump 914, to a precursor source 916, and to a gas source 918.

ALD operates in the so-called ALD temperature window above a precursor saturation threshold, where the growth rate does not depend on the amount of introduced precursors, such that the growth is self-limiting, and the overall layer width depends only on the number of ALD cycles. As the precursor is introduced into the reaction chamber by pulses, a certain pulse duration is needed to achieve saturation. An ALD cycle, e.g., for an oxide, metal, or nitride deposition, typically comprises four sub cycles: firstly, organic or inorganic precursor for oxides, metals, or nitrides, secondly, a purge step, thirdly, an oxidizer, hydrogen plasma, or nitrogen precursor such as, e.g., ammonia, nitrogen gas, nitrogen plasma, and fourthly, a purge step to produce typically less than one monolayer of a metal oxide per cycle. The GPC is generally limited by the size and the reactivity of the precursor.

With the reactor 900, due to the provision of a base stage rotation axis and an additional substrate rotation axis it is possible to achieve a three dimensional - in addition to the higher deposition rates - cycle-controlled conformal growth with atomic layer width precision and roughness (RMS) as required for FZPs suitable for photon energies of 8 keV or more. For reactor 900, an ALD cycle is defined by one full rotation of the base stage, with the substrate being rotated under each of the four segments. The pulse time is then given by the dwell time of the substrate under each shower head segment. The growth rate can then be converted from GPC to a growth rate by multiplying GPC with the base stage rotation frequency.

In operation of the reactor 900 for conducting an ALD process, the base stage 908 is heated and is rotated at times. Arranged on the base stage 908 there are substrate holders (not shown) on which substrates (not shown) such as fibres are mounted for the deposition process. The substrate holders are arranged on the base stage 908 in a circular pattern. The substrate holders can be rotated, e.g., independently, relative to the base stage 908. Preferably, the substrate holders have the capability to be individually heated in addition to the heated base stage 908.

When using the ALD process for fabricating a FZP, alternating layers of material A and martial B are deposited with different physical properties. Material A or B can be of one of the following types: e.g. (Metal)Oxide, (Metal)Nitride, Metal. The thickness of the individual deposited layers and the resulting width of the zones, respectively, and the total number of layers or zones of the FZP, respectively, follow Fresnel's zone law. Preferably, the material for A and B is selected such that material A has a suitable X-ray contrast and/or phase shift with respect to material B in the desired photon energy range and material A and/or B have self-smoothing properties (during deposition) of a least one of the two materials, e.g. $Al_2O_3$. In the ALD process it can be beneficial if an adaptive control of the deposition parameters is required, e.g. based on a sensor input, e.g., by quartz microbalance, a reflection measurement, a reflectance anisotropy spectroscopy (RAS), or spectroscopic ellipsometry.

In particular, an ALD process for fabricating a FZP with the reactor 900 may comprise one or more of the following steps:

- providing a substrate, e.g., glass fibre or metal wire with large roundness, that is a solid fibre, straight or tapered as described with reference to figure 3,

- chemical pre-cleaning, e.g. aqua regia, piranha, chromerge, de-greasing with organic solvents,

- mounting the substrate on a substrate holder which allow additional rotation along the axis of the substrate,

- in-system cleaning, e.g. with a $CO_2$ snow gun,

- transfer of the substrate to the reaction chamber onto a rotating and heated substrate holder,

- engaging the substrate rotation axis on the substrate holder itself,

- surface functionalization, e.g. OH, NH, C surface termination, to facilitate material growth

- depositing alternating layers of oxide A and oxide B until desired zone width is achieved,

- continuous rotating the substrate around the base stage rotation axis under alternating preferably continuous streams of a first precursor or reaction gas, a purge gas or gas bearing stream, a second precursor or reaction gas, e.g., an oxidizer, and switching of gas streams according to recipe for oxide A and oxide B,

- changing of arc sub-segment functionally (precursor, gas or exhaust) for the two precursor segments as well as a substrate-to-shower head distance d to change the deposition profile along the substrate in order to vary deposition layer thickness along the central axis of the substrate, and

- covering of substrate (in-system) by a protective coating, e.g. SiOz.

Additional deposition of a metal layer, e.g., to achieve higher phase contrast, instead of an oxide can be done. In this case, the FZP consists of a rotation-symmetric substrate, e.g., a glass fibre, or metal wire, with alternating layers of metal and oxides. Here the oxidizer precursor is preferably exchanged with a gas stream from a hydrogen plasma source.

After conducting the ALD process, for fabricating the FZP, the following steps may be performed:

- slicing of the coated substrate to desired FZP height, e.g. via focused ion beam,

- further mechanical or chemical polishing of the sides of the FZP, and

- mounting the FZP on a suitable X-ray transparent membrane, e.g. $Si_3N_4$.

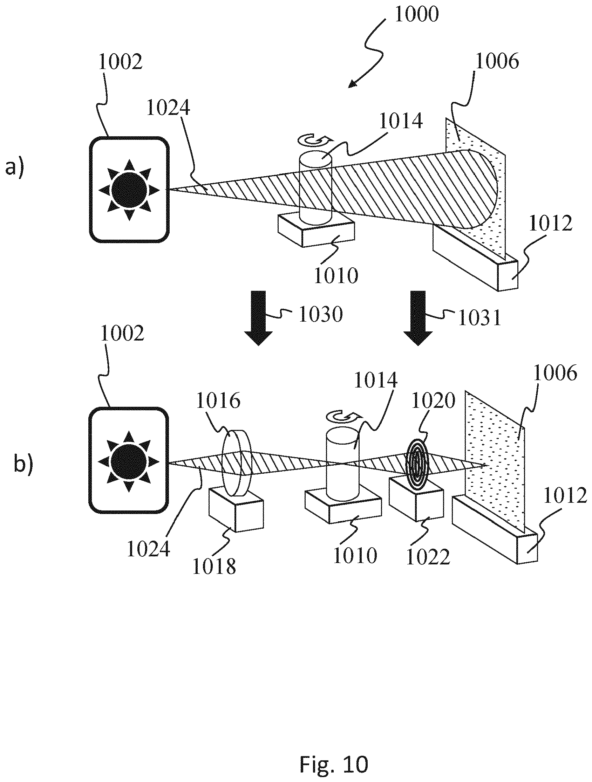

Figure 10 schematically and exemplary shows those components of an X-ray microscope 1000 that participate in the generation of a sub-micrometre resolution image of an object in the micro X-ray imaging mode and those components of the X-ray microscope 1000 that participate in the generation of a nanometre resolution image of an object in the nano X-ray imaging mode.

The X-ray microscope 1000 comprises for the micro X-ray imaging mode a source 1002 configured for emitting X-ray radiation, a 2D X-ray detector for imaging 1006, a 4-axis stage for sample object movement 1010, a 5-axis stage for detector 1012. Depicted is also a sample object 1014 that does not form part of the X-ray microscope 1000. When changing to the nano X-ray imaging mode, a first X-ray optic 1016 on a 5-axis stage 1018 and a second X-ray optic 1020 on 6-axis stage 1022 are moved 1030 and 1031 into the X-ray beam path 1024. The second X-ray optic 1020 is a FZP that is configured, e.g., as the FZP 100 described with reference to Fig. 1.

Due to two imaging modes, i.e., the micro X-ray imaging mode and the nano X-ray imaging mode, the X-ray microscope 1000 combines high spatial resolution and deep object penetration. A small spot, high X-ray energy source provides the same high penetration for both imaging modes, from-micro-to-nano with seamless micro-to-nano imaging without cutting or special sample object preparation.

In the micro X-ray imaging mode, the X-ray microscope 1000 imaging subsystem produces 2D images of the sample object imaged with micrometre resolution. For the use case, this resolution is advantageous and useful to localize features of interest, e.g., defects, deep inside the sample object to select a 2D or 3D region of interest to subsequently image to nano-scale resolution in the nano X-ray imaging mode. The micro X-ray imaging mode subsystem shares the X-ray source, sample object manipulator, and X-ray detector with the nano X-ray imaging mode subsystem, as well as system control and interfaces including GUI.

In the nano X-ray imaging mode, the nano X-ray imaging mode subsystem may produce 2D images of the sample object imaged with nanometre scale resolution. For the use case, it produces the high-resolution 2D images needed to clearly visualize and localize defects such as microcracks in micro solder bumps or voids and delamination in through-silicon-vias in vertically integrated microchips and in chiplets. The nano X-ray imaging mode subsystem shares the X-ray source, sample object manipulator, and X-ray detector with the micro X-ray imaging mode subsystem, as well as the computer controls and interface (GUI). The nano X-ray imaging mode subsystem integrates into the X-ray microscope 1000 a capability to insert the two X-ray optics that are needed for nano-imaging into the beam path. For transitioning between the micro X-ray imaging mode and the nano X-ray imaging mode, the first X-ray optic and the second X-ray optic are moved into or out of the beam path.

The X-ray microscope 1000 can be operated at monochromatic high photon energies above 8 keV with a high-power X-ray source to penetrate thick objects, e.g., using a liquid metal jet X-ray source, excited by electrons conventionally or with a laser-induced plasma. With the FZP, it is possible to maintain the object penetration and at the same time to generate nano-scale resolution images. In the micro X-ray imaging mode it is possible to navigate on the sample object and generate 2D or 3-D lower resolution overviews of the sample object. The transition between micro-scale and nano-scale imaging can be performed seamless and transparent to a user without sample object shuttle to another tool and without navigation procedures. To transition from the projection based micro-scale imaging mode to the nano-scale imaging mode, the first X-ray optic 1016 and the second X-ray optic 1020 are inserted (1030, 1031) into the beam path 1024. Adjustments due to, e.g., mechanical or thermal instabilities may be handled with a neural-network assisted alignment, or closed loop sensor-based alignment, e.g. an interferometric, capacitive, or image sensor based alignment system.

It is thus preferred that machine learning based procedures are provided to assist a user in the setup of the X-ray microscope 1000 and in multi-scale image and data analysis. With the X-ray microscope 1000 complicated, time consuming, error prone, and much more expensive workflows may be reduced or avoided. A control unit comprising a trained neural network may use data from both, the micro X-ray imaging mode and the nano X-ray imaging mode to produce clear, high-resolution images with minimal artefacts of the 3-D region of interest. Particularly, neural network-based algorithms may be incorporated into 3-D reconstruction algorithms comprised by the control unit to mitigate image artefacts caused by experimental errors, e.g., poisoning of components, thermal drift of sample object and component and to reduce the image acquisition time by introducing a monitored tomographic reconstruction approach. Preferably, the control unit's neural network is trained for controlling a transition of the first X-ray optic and the second X-ray optic into and out of the beam path in order to switch between micro and nano X-ray imaging modes as well as for alignment of the first X-ray optic and the second X-ray optic.

Preferably, the X-ray microscope 1000 provides a small spot, preferably, of less than or equal to 50 $\mu$m, high energies of 8 keV or more, an X-ray source(s) with high photon flux, and high brilliance. Preferably, the X-ray microscope 1000 provides monochromatic or monochromatized X-rays.

The second X-ray optic, i.e., the FZP, may be arranged on a linear moving or rotating lens turret to switch between different optics such as a further comprised multi-layer Laue lens.

Preferably, the first X-ray optic and the second X-ray optic can be configured/exchanged for different photon energies to cover a range of at least 8 to 25 keV.

Preferably, the first X-ray optic has monochromatizing capabilities, e.g., the first X-ray optic may be coated or uncoated and may comprise two 2D focusing mirrors, elliptical mirrors, capillaries, or condenser optics. Preferably, a photon energy is tuneable via the monochromator, e.g., in a range of at least 8 to 25 keV. With a focusing monochromator it is possible to obtain images for a single wavelength with a certain photon energy bandwidth, e.g., $\frac{E}{\Delta E} > 100$. Tuning the photon energy via monochromator and keeping the illuminated image position on the sample object constant may require moving other X-ray optics and sample object positions accordingly. This may result in an energy resolved image, e.g., each pixel on the detector may record an X-ray absorption spectrum. The X-ray microscope 1000 may comprise an adaptive or closed loop or neural network-based positioning system, e.g., as part of the control unit, e.g., a laser interferometer, to guide the transition from micro to nano X-ray imaging mode. The multiple axis on multiple elements may be used to compensate for temperature fluctuations. The X-ray microscope 1000 preferably further comprises a fully enclosed cabinet. Preferably, the X-ray microscope 1000 can be regulated with respect to the internal temperature and humidity inside the X-ray cabinet. For example, the X-ray microscope 1000 may comprise an internal temperature and/or air distribution system.

Additionally, or alternatively, the first optical X-ray optic 1016 can be a double mirror monochromator. The photon energy can preferably be changed with the monochromator resulting, e.g., in a monochromatic 2D image on the detector 1006. By scanning the photon energy in the acceptable window for the second X-ray optic 1020, laterally resolved X-ray absorption spectra (XAS) can be obtained. To cover a wide range of energies, e.g., absorption edges, several second X-ray optics may be employed, which can be preferably mounted on a rotating lens turret.

In the claims, the word "comprising" does not exclude other elements or steps, and the indefinite article "a" or "an" does not exclude a plurality.

A single unit or device may fulfil the functions of several items recited in the claims. The mere fact that certain measures are recited in mutually different dependent claims does not indicate that a combination of these measures cannot be used to advantage.

Any reference signs in the claims should not be construed as limiting the scope.

## Claims

1. A reactor for depositing one or more atomic layers of at least one material onto a substrate, the reactor comprising:

    - a reaction chamber, the reaction chamber accommodating
    - a showerhead comprising at least one gas outlet that is configured for providing a gas stream of at least one precursor or of at least one reaction gas or of at least one component of the at least one material,
    - a base stage that is rotatable around a base stage rotation axis, and
    - at least one substrate holder that is arranged on the base stage and configured for rotating the substrate around a substrate rotation axis in such a way that the base stage rotation axis and the substrate rotation axis are inclined with respect to each other.

2. The reactor according to claim 1, wherein the at least one substrate holder comprises a substrate holder driving mechanism that includes a motor and connected thereto a substrate mounting support for holding the substrate and rotating the substrate around the substrate rotation axis.

3. The reactor according to claim 1 or 2, comprising a plurality of substrate holders arranged on the base stage, wherein each of the plurality of substrate holders is independently rotatable relative to the base stage about a respective substrate rotation axis.

4. The reactor according to at least one of the preceding claims, wherein the at least one substrate holder can be releasably mounted onto the base stage.

5. The reactor according to at least one of the preceding claims, wherein the substrate holder is arranged and configured to rotate the substrate with the substrate rotation axis being substantially perpendicular to the base stage rotation axis.

6. The reactor according to at least one of the preceding claims, comprising a base stage heating element with which the base stage can be heated, or a radiation source for providing infrared radiation, wherein the radiation source is configured and arranged to provide infrared radiation heating spots so that a substrate held by the substrate holder can be heated in spatially localized areas.

7. The reactor according to at least one of the preceding claims, comprising a substrate holder heating element arranged and adapted to heat the at least one substrate holder.

8. The reactor according to at least one of the preceding claims, wherein the showerhead is divided spatially into four area sections, and wherein in a first section there is a first gas outlet for providing a first gas stream comprising a first precursor or reaction gas to be deposited and/or at least one component of the to be deposited material, in a second section there is a second gas outlet for introducing a first purge gas, in a third section there is a third gas outlet for providing a second gas stream comprising a second precursor or reaction gas to be deposited and/or at least one component of the to be deposited material, and in a fourth section there is a fourth gas outlet for introducing a second purge gas.

9. A method of depositing one or more atomic layers of at least one material onto a substrate by means of a reactor according to at least one of the preceding claims, the method comprising the steps of:

    - arranging the substrate on the at least one substrate holder,
    - arranging the substrate holder with the substrate on the base stage in the reaction chamber,
    - introducing the gas stream comprising the at least one precursor, reaction gas and/or at least one component of the at least one material through the at least one gas outlet into the reaction chamber,
- rotating the substrate about the base stage rotation axis with the base stage and additionally rotating the substrate about the substrate rotation axis with the substrate holder, the base stage rotation axis and the substrate rotation axis being inclined to each other, and
- depositing one or more atomic layers of the at least one material and/or the at least one component of the at least one material on the substrate.

10. The method according to claim 9, wherein alternating layers of a first material and a second material with controlled thicknesses are deposited onto the substrate in the form of concentric rings, the first material and the second material differing in at least one physical property.

11. The method according to claim 9 or 10, wherein the at least one material is deposited at a deposition rate of 1 nm per minute or more, preferably, of 10 nm per minute or more.

12. The method according to at least one of claims 9 to 11, comprising cleaning the substrate prior or after to arranging the substrate holder with the substrate on the base stage in the reaction chamber or a pre-chamber by means of a $CO_2$ snow gun, ozone source and/or generator, a plasma source, by means of sputtering or etching.

13. A use of the reactor of at least one of claims 1 to 8 for producing a Fresnel zone plate, the Fresnel zone plate comprising a first material and a second material arranged alternately in a sequence of concentric rings following Fresnel's zone plate law, the Fresnel zone plate having an aspect ratio of an outermost zone of 50 or more and an outermost zone with a zone width of 50 nm or less and/or the Fresnel zone plate having a layer width accuracy $\Delta w(RMS)/w$ of 0.01 or less, an roundness of the respective zones of $R \geq 1 - \frac{1/2 \cdot w_N}{b}$ or more, where $w_N$ denotes the width of the outermost zone, and/or having an aspect ratio of the outermost zone of 50 or more.

14. An X-ray microscope for producing a magnified image of an object using X-rays, the X-ray microscope comprising

- an X-ray detector for detecting X-rays provided by an X-ray source and penetrating the object,
- a first X-ray optic that can be automatically moved into and out of an X-ray beam path between the X-ray source and the object, and
- a second X-ray optic that is a Fresnel zone plate comprising a first material and a second material arranged alternately in a sequence of concentric rings following Fresnel's zone plate law, the Fresnel zone plate having an aspect ratio of an outermost zone of 50 or more and an outermost zone with a zone width of 50 nm or less and/or the Fresnel zone plate having a layer width accuracy $\Delta w(RMS)/w$ of 0.01 or less, an roundness of the respective zones of

$$R \geq 1 - \frac{1/2 \cdot w_N}{b}$$ or more, where $w_N$ denotes the width of the outermost zone, and/or having an aspect ratio of the outermost zone of 50 or more, and that can be automatically moved into and out of an X-ray beam path between the object and the X-ray detector, and
- a control unit that is configured for

- controlling the automatic movements of the first X-ray optic and the second X-ray optic into and out of the beam path, and
- aligning the first X-ray optic and the second X-ray optic with respect to the beam path, wherein

for producing in micro a X-ray imaging mode an image of the object with micrometre resolution, the first X-ray optic and the second X-ray optic can be moved out of the beam path and for producing in a nano X-ray imaging mode an image of the object with nanometre resolution, the first X-ray optic and the second X-ray optic can be moved into the beam path.

15. The X-ray microscope according to claim 14, comprising a positioning system that is arranged and configured for guiding a transition from the micro a X-ray imaging mode to the nano X-ray imaging mode and vice versa.

Fig. 1

Fig. 2

300          310

Fig. 3

Fig. 4

Fig. 5

Fig. 6

Fig. 7

Fig. 8

Fig. 9

Fig. 10

**EP 4 477 777 A1**

Europäisches
Patentamt

European
Patent Office

Office européen
des brevets

## EUROPEAN SEARCH REPORT

**Application Number**

EP 23 17 8911

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | LI YANLI ET AL: "Fabrication of multilayer Fresnel zone plate for hard X-ray microscopy by atomic layer deposition and focused ion beam milling", VACUUM., vol. 209, 1 March 2023 (2023-03-01), page 111776, XP093100973, GB ISSN: 0042-207X, DOI: 10.1016/j.vacuum.2022.111776 * the whole document * | 1-15 | INV. C23C16/455 C23C16/458 C23C16/44 C23C16/46 G21K7/00 G02B3/08 G02B5/18 G21K1/06 C23C16/02 |
| X | SANLI UMUT TUNCA ET AL: "3D Nanofabrication of High-Resolution Multilayer Fresnel Zone Plates", ADVANCED SCIENCE, [Online] vol. 5, no. 9, 5 June 2018 (2018-06-05), XP093100972, ISSN: 2198-3844, DOI: 10.1002/advs.201800346 Retrieved from the Internet: URL:https://api.wiley.com/onlinelibrary/td m/v1/articles/10.1002%2Fadvs.201800346> [retrieved on 2023-11-10] * the whole document * | 14,15 | |
| X | KR 2022 0167906 A (WONIK IPS CO LTD [KR]) 22 December 2022 (2022-12-22) * the whole document * | 1-9,11, 12 | **TECHNICAL FIELDS SEARCHED (IPC)** C23C H05G G21K G02B |
| X | WO 2023/080368 A1 (HANWHA CORP [KR]) 11 May 2023 (2023-05-11) * the whole document * | 1-9,11, 12 | |
| A | US 2009/206535 A1 (MACIONCZYK FRANK [DE]) 20 August 2009 (2009-08-20) * figures * | 1,3,4,9 | |

-/--

The present search report has been drawn up for all claims

| Place of search | Date of completion of the search | Examiner |
|---|---|---|
| The Hague | 16 November 2023 | Engelen, Karen |

**Europäisches Patentamt**
**European Patent Office**
**Office européen des brevets**

# EUROPEAN SEARCH REPORT

Application Number

EP 23 17 8911

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2023/151478 A1 (MACIONCZYK FRANK [DE] ET AL) 18 May 2023 (2023-05-18) <br> * figures * <br> ----- | 1,3,4,9 | |
| A | HANFEI YAN ET AL: "Hard x-ray nanofocusing by multilayer Laue lenses", JOURNAL OF PHYSICS D: APPLIED PHYSICS, INSTITUTE OF PHYSICS PUBLISHING, BRISTOL, GB, <br> vol. 47, no. 26, 5 June 2014 (2014-06-05), page 263001, XP020266380, ISSN: 0022-3727, DOI: 10.1088/0022-3727/47/26/263001 [retrieved on 2014-06-05] <br> * figure 1a * <br> ----- | 10,13 | |
| X,D | WO 2011/054651 A1 (MAX PLANCK GESELLSCHAFT [DE]; SCHUETZ GISELA [DE] ET AL.) 12 May 2011 (2011-05-12) <br> * claims * <br> ----- | 1-15 | |

**TECHNICAL FIELDS SEARCHED (IPC)**

The present search report has been drawn up for all claims

| Place of search | Date of completion of the search | Examiner |
|---|---|---|
| The Hague | 16 November 2023 | Engelen, Karen |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
 
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 17 8911

This annex lists the patent family members relating to the patent documents cited in the above-mentioned European search report.
The members are as contained in the European Patent Office EDP file on
The European Patent Office is in no way liable for these particulars which are merely given for the purpose of information.

16-11-2023

| Patent document cited in search report | | Publication date | Patent family member(s) | | Publication date |
|---|---|---|---|---|---|
| KR 20220167906 | A | 22-12-2022 | NONE | | |
| WO 2023080368 | A1 | 11-05-2023 | KR | 20230064110 A | 10-05-2023 |
| | | | TW | 202320257 A | 16-05-2023 |
| | | | WO | 2023080368 A1 | 11-05-2023 |
| US 2009206535 | A1 | 20-08-2009 | CN | 101512039 A | 19-08-2009 |
| | | | DE | 102006041137 A1 | 20-03-2008 |
| | | | EP | 2057299 A1 | 13-05-2009 |
| | | | JP | 2010501734 A | 21-01-2010 |
| | | | US | 2009206535 A1 | 20-08-2009 |
| | | | WO | 2008025519 A1 | 06-03-2008 |
| US 2023151478 | A1 | 18-05-2023 | BR | 112023000643 A2 | 31-01-2023 |
| | | | CN | 115812110 A | 17-03-2023 |
| | | | DE | 102020118367 A1 | 13-01-2022 |
| | | | EP | 4179126 A1 | 17-05-2023 |
| | | | JP | 2023529015 A | 06-07-2023 |
| | | | US | 2023151478 A1 | 18-05-2023 |
| | | | WO | 2022012955 A1 | 20-01-2022 |
| WO 2011054651 | A1 | 12-05-2011 | DE | 102010010937 A1 | 28-04-2011 |
| | | | EP | 2504725 A1 | 03-10-2012 |
| | | | JP | 5784028 B2 | 24-09-2015 |
| | | | JP | 2013508735 A | 07-03-2013 |
| | | | US | 2012258243 A1 | 11-10-2012 |
| | | | WO | 2011054651 A1 | 12-05-2011 |

EPO FORM P0459

For more details about this annex : see Official Journal of the European Patent Office, No. 12/82

## REFERENCES CITED IN THE DESCRIPTION

**Patent documents cited in the description**

- WO 2011054651 A1

**Non-patent literature cited in the description**

- **ALEXEI N. KUROKHTIN** ; **ALEXEI V. POPOV**. Simulation of high-resolution x-ray zone plates. *J. Opt. Soc. Am. A*, 2002, vol. 19, 315-324
- **Y. VLADIMIRSKY** ; **D.P. KERN** ; **T.H.P. CHANG** ; **D.T. ATTWOOD** ; **N. ISKANDER** ; **S. ROTHMAN** ; **K. MCQUAIDE** ; **J. KIRZ** ; **H. ADE** ; **I. MCNULTY**. Zone plate lenses for X-ray microscopy. *Nuclear Instruments and Methods in Physics Research Section A: Accelerators, Spectrometers, Detectors and Associated Equipment*, 1988, vol. 266 (1-3), ISSN 0168-9002, 324-328

- **MYERS**. Smoothing surface roughness using Al2O3 atomic layer deposition. *Applied Surface Science*, 2021, vol. 569, 150878
- **SANLI**. 3D Nanoprinted Plastic Kinoform X-Ray Optics. *Advanced Materials*, 2018, vol. 30, 1802503